# EUROPEAN PATENT APPLICATION

(11) **EP 0 583 493 A1**
(43) Date of publication of application: **23.02.1994**
(21) Application number: 92113914.3
(22) Date of filing: 14.08.1992
(51) Int. Cl.: H03K 3/57

(54) **Current pulse generator**

(71) Applicant: "FHC" ABWASSERTECHNIK Ges.m.b.H., A-8960 Öblarn 218 (AT)
(72) Inventor: Shevchenko, Anatolij A., A-8983 Bad Mitterndorf 130 (AT)

(57) **Abstract**

Ein Stromimpulsgenerator mit einer Gleichspannungsquelle (1), mit einem Lade-/Entladekreis aus einer zwischen eine Klemme der Gleichstromquelle (1) und eine Last (3) geschalteten Reihenschaltung aus einem Ladethyristor (4), einer Drossel (5) und einem Entladethyristor (7), einem zum Entladethyristor (7) und zur Last (3) parallelgeschalteten Kondensator (6) und einem zwischen Ladethyristor (4) und Drossel (5) angeschlossenen Ladungsaustauschthyristor (8), wobei der jeweils zweite Anschluß der Last (3), des Kondensators (6) und des Ladungsaustauschthyristors (8) über eine gemeinsame Leitung (2) auf die zweite Klemme der Gleichstromquelle (1) geschaltet ist, und mit einer Steuerschaltung (9), deren Ausgänge mit den Steueranschlüssen der Thyristoren (4, 7, 8) verbunden sind, weist erfindungsgemäß mehrere parallel zueinander geschaltete Lade-/Entladekreise auf, wobei in jedem Entladekreis nur ein Entladethyristor (7) vorgesehen ist.

Durch die erfindungsgemäßen Maßnahmen werden Leistung und Zuverlässigkeit erhöht und die funktionellen Möglichkeiten erweitert.

## Description

Die Erfindung bezieht sich auf einen Stromimpulsgenerator mit einer Gleichspannungsquelle, mit einem Lade-/Entladekreis aus einer zwischen eine Klemme der Gleichstromquelle und eine Last geschalteten Reihenschaltung aus einem Ladethyristor, einer Drossel und einem Entladethyristor, einem zum Entladethyristor und zur Last parallelgeschalteten Kondensator und einem zwischen Ladethyristor und Drossel angeschlossenen Ladungsaustauschthyristor, wobei der jeweils zweite Anschluß der Last, des Kondensators und des Ladungsaustauschthyristors über eine gemeinsame Leitung auf die zweite Klemme der Gleichstromquelle geschaltet ist, und mit einer Steuerschaltung, deren Ausgänge mit den Steueranschlüssen der Thyristoren verbunden sind. Ein solcher Thyristor-Stromimpulsgenerator ist aus der SU-A-1 274 124 bekannt.

Aus der SU-A-808 228 ist bereits ein Stromimpulsgenerator zum Dispergieren von Metallen durch Elektroerosion bekannt. An seine Gleichstromquelle ist ein Ladekondensator angeschlossen, zu dem die Erosionslast parallelgeschaltet ist. Der Last vorgeschaltet ist ein Thyristorschalter, der mehrere zueinander parallel geschaltete Thyristoren aufweist, die von einer Steuerschaltung angesteuert werden. Mehrere parallel zueinander geschaltete Thyristoren sind notwendig, um eine ausreichend hohe Vorderflankensteilheit di/dt des Stromimpulses zu erzielen, damit zwischen den Elektroden der Erosionslast eine Funkenentladung entsteht, sowie dazu, eine ausreichend hohe Leistung der Impulse und des gesamten Generators zu erreichen, was eine Voraussetzung für eine hohe Produktivität ist.

Der bekannte Stromimpulsgenerator ist im Betrieb unzuverlässig, weil die Thyristoren keine ideale Charakteristik haben und jeder gegenüber dem Durchlaßstrom einen unterschiedlichen Widerstand aufweist, wodurch einige Thyristoren unvollständig ausgelastet und andere überlastet werden, so daß sie verhältnismäßig schnell ausfallen.

Aus der SU-A-1 197 066 ist ein Stromimpulsgenerator zur elektroerosiven Dispersion stromleitender Materialien bekannt, der ähnlich aufgebaut ist wie der aus der SU-A-808 228 bekannte. Zur Steigerung der Betriebszuverlässigkeit des Thyristorschalters ist den Steuerelektroden der parallel geschalteten Entladethyristoren je ein Widerstand vorgeschaltet. Zusätzlich ist ein Thyristor vorgesehen, der eine Klemme der Gleichspannungsquelle mit den Vorwiderständen der Steuerelektroden verbindet. Der bekannte Stromimpulsgenerator ist verhältnismäßig kompliziert aufgebaut und gegen eine Überladung des Kondensators ungeschützt, wenn in der Last ein Betriebszustand eintritt, der einem Kurzschluß nahekommt.

Bei dem eingangs beschriebenen Stromimpulsgenerator, der ebenfalls zur elektroerosiven Dispersion von Metallen dient, wird der Ladethyristor über einen Impuls der Steuerschaltung freigegeben und der Kondensator aus der Gleichspannungsquelle über die Drossel des Ladekreises im Schwingbetrieb fast auf die doppelte Speisespannung aufgeladen. Durch nachfolgendes Einschalten des Ladungsaustauschthyristors durch ein Signal von der Steuerschaltung wird der Kondensator über dieselbe Drossel neu aufgeladen und der Ladungsaustauschthyristor gesperrt. Durch nachfolgendes Einschalten des Entladethyristors durch ein Signal von der Steuerschaltung wird der Kondensator über den Entladekreis auf die Last entladen. Die Drossel im Ladekreis ermöglicht es, die Betriebsspannung am Kondensator und an den Elektroden der Last fast zu verdoppeln. Dies wiederum erlaubt eine Erhöhung der an die Last abgegebenen Leistung. Die Neuladung des Kondensators über den Ladungsaustauschthyristor ist bei diesem Generator deswegen notwendig, weil die Thyristoren des Entladekreises bei der beschriebenen Schaltung gegenläufig zum Ladethyristor des Ladekreises geschaltet sind. Sinn dieser Schaltung ist es, bei Kurzschlüssen keinen Gleichstrom von der Gleichspannungsquelle auf die Erosionslast gelangen zu lassen.

Nachteil dieses bekannten Impulsgenerators ist es, daß die Entlade-Impulsfolgefrequenz durch die maximal zulässige Frequenz der Entladethyristoren beschränkt ist. Da ebenfalls mehrere Thyristoren im Schalter parallelgeschaltet sind, werden einige von ihnen unvollständig ausgelastet, andere dagegen überlastet. Dies beeinträchtigt die Zuverlässigkeit des Generators und ermöglicht es nicht, die Leistung durch Erhöhung der Anzahl parallelgeschalteter Entladethyristoren zu steigern.

Der Erfindung liegt die Aufgabe zugrunde, einen Stromimpulsgenerator mit erhöhter Leistung und Zuverlässigkeit sowie erweiterten funktionellen Möglichkeiten zu schaffen.

Diese Aufgabe wird erfindungsgemäß ausgehend von dem gattungsgemäßen Stromimpulsgenerator dadurch gelöst, daß mehrere Lade-/Entladekreise parallel zueinander geschaltet sind und in jedem Entladekreis nur ein Entladethyristor vorgesehen ist.

Zwar ist es an sich bekannt, mehrere parallel zueinander geschaltete Lade-/Entladekreise in einem Stromimpulsgenerator vorzusehen. So ist in der SU-A-1 231 582 ein Stromimpulsgenerator zur Versorgung von Vorrichtungen zur Dispergierung von Metallen beschrieben, bei dem zwei zueinander parallele Lade-/Entladekreise vorgesehen sind, die je einen Ladethyristor, einen Kondensator und einen Entladethyristor enthalten. Dabei ist an jeden Entladekreis ein Austauschkreis angeschlossen. Es ist jedoch keine gemeinsame Leitung vorgesehen, was zu einer größeren Anzahl von Schienen und infolgedessen zu einer komplizierten Konstruktion führt. Außerdem hat der bekannte Generator zwei Drosseln, nämlich eine Lade- und eine Ladeaustauschdrossel. Erfindungsgemäß wird dagegen für beide Funktionen (Laden und Ladungsaustausch) dieselbe Drossel verwendet, wodurch die Konstruktion vereinfacht wird. Außerdem sind bei dem erfindungsgemäßen Stromimpulsgenerator in den Austauschkreisen steuerbare Thyristoren vorgesehen, während bei dem bekannten Generator nicht steuerbare Dioden verwendet werden. Hierdurch können die funktionellen Möglichkeiten des erfindungsgemäßen Generators erweitert werden. Bei dem erfindungsgemäßen Generator sind alle N Entladekreise auf dasselbe Elektrodenpaar der Last geschaltet, während bei dem bekannten Generator jeder Entladekreis auf ein eigenes, separates Elektrodenpaar der Last geschaltet ist. Dies bedingt auch die unterschiedlichen funktionellen Bestimmungszwecke des erfindungsgemäßen und des bekannten Generators. Schließlich ist beim erfindungsgemäßen Generator die Anzahl der parallelen Lade-/Entladekreise nicht beschränkt, während bei dem bekannten Generator durch die besonderen Gegebenheiten der Schaltung höchstens zwei Lade-/Entladekreise vorhanden sein können.

Weil erfindungsgemäß statt nur eines mehrere parallelgeschaltete Lade-/Entladekreise vorgesehen sind, kann die Leistung des Stromimpulsgenerators durch Summierung der Leistungen der einzelnen Kreise erhöht und die Summen-Impulsfrequenz in der Last gesteigert werden, wenn die Entladethyristoren nacheinander gezündet werden. Weil sich in jedem Entladekreis nur ein Entladethyristor befindet, sind keine Maßnahmen zur Stromangleichung in den Entladethyristoren erforderlich, die den Aufbau komplizieren und bei dem gattungsgemäßen Stromimpulsgenerator erforderlich waren, der mehrere parallel zueinander geschaltete Entladethyristoren aufweist. Dies führt zu einer höheren Zuverlässigkeit des erfindungsgemäßen Generators im Betrieb.

Bei einer bevorzugten Weiterbildung des erfindungsgemäßen Stromimpulsgenerators sind jeder Reihenschaltung aus Drossel und Entladethyristor eine oder mehrere Reihenschaltungen aus je einer Drossel und einem Entladethyristor parallelgeschaltet, wobei je ein Kondensator an jede Verbindungsstelle zwischen je einer Drossel und einem Entladethyristor angeschlossen ist.

Bei dieser Weiterbildung kann die Anzahl der Zweige der Lade-/Entladekreise weiter erhöht und folglich sowohl die Leistung als auch die Impulsflankensteilheit des Stromes in der Last weiter erhöht werden.

Die Verwendung mehrerer parallel zueinander geschalteter Drosseln ist zwar aus der SU-A-1 338 016 für eine Vorrichtung zum Aufladen von Speicherkondensatoren bekannt. Allerdings sind hier nur zwei Drosseln parallel zueinander geschaltet, während erfindungsgemäß beliebig viele Drosseln parallel geschaltet sein können. Dabei ist beim erfindungsgemäßen Stromimpulsgenerator ein Anschluß jeder Drossel an den gemeinsamen Ladethyristor und der andere an die Wicklung des zugehörigen Speicherkondensators angeschlossen. Nach der SU-A-1 338 016 ist hingegen je ein Anschluß jeder der beiden Drosseln direkt an die Klemme der Gleichspannungsquelle und der andere an den Ladekreis angeschlossen, der mehrere parallel zueinander geschaltete Ladethyristoren aufweist.

Bei einer weiteren bevorzugten Ausführungsform des erfindungsgemäßen Stromimpulsgenerators ist zwischen die Verbindungsstellen zwischen den Lade- und den Ladungsaustauschthyristoren und die Drosseln der parallelgeschalteten Reihenschaltungen aus Drossel und Entladethyristor je eine zusätzliche Drossel geschaltet; mit anderen Worten, den parallel geschalteten Reihenschaltungen aus Drossel und Entladethyristor ist je eine Drossel vorgeschaltet. Hierdurch werden die Abmessungen und die Summenmasse der Drosseln verringert.

Zusammenfassend läßt sich feststellen, daß durch den erfindungsgemäßen Stromimpulsgenerator gegenüber dem gattungsgemäßen folgende Vorteile erzielt werden:
- Erhöhung der Leistung in der Last durch Summierung der mittleren Leistung der einzelnen Entladekreise sowie durch Summierung der Amplituden der Entladestromimpulse der einzelnen Entladekreise,
- Erhöhung der Stromimpuls-Flankensteilheit di/dt der Entladung in der Last auf Werte, die über den zulässigen Grenzwerten der Entladethyristoren liegen,
- Erhöhung und leichte Regulierung der Impulsfolgefrequenz in der Last innerhalb eines weiten Bandbereiches,
- Erweiterung der funktionellen Möglichkeiten des Stromimpulsgenerators, der leicht von der Betriebsart mit einzeln gezündeten Entladethyristoren auf die Betriebsart mit gleichzeitig bzw. gruppenweise gezündeten Thyristoren umstellbar ist,
- Erhöhung der Zuverlässigkeit im Betrieb durch Vermeidung einer ungleichmäßigen Entladestromverteilung zwischen parallelgeschalteten Entladethyristoren,
- Verringerung des spezifischen Materialaufwandes bezogen auf die Leistung, weil ein gemeinsamer Stromleiter verwendet und die Anzahl der Lade- und Ladungsaustauschthyristoren sowie die Anzahl der Drosseln, ihre Kupfermasse und ihre Abmessungen verringert werden.

Im folgenden werden Ausführungsbeispiele des erfindungsgemäßen Stromimpulsgenerators anhand der Zeichnungen erläutert. Es zeigen:
- Fig. 1: das Schaltbild einer ersten und
- Fig. 2: einer zweiten Ausführungsform des Stromimpulsgenerators nach Patentanspruch 1,
- Fig. 3: das Schaltbild einer ersten und
- Fig. 4: einer zweiten Ausführungsform des Stromimpulsgenerators nach Patentanspruch 2, und
- Fig. 5: das Schaltbild eines Stromimpulsgenerators nach Patentanspruch 3.

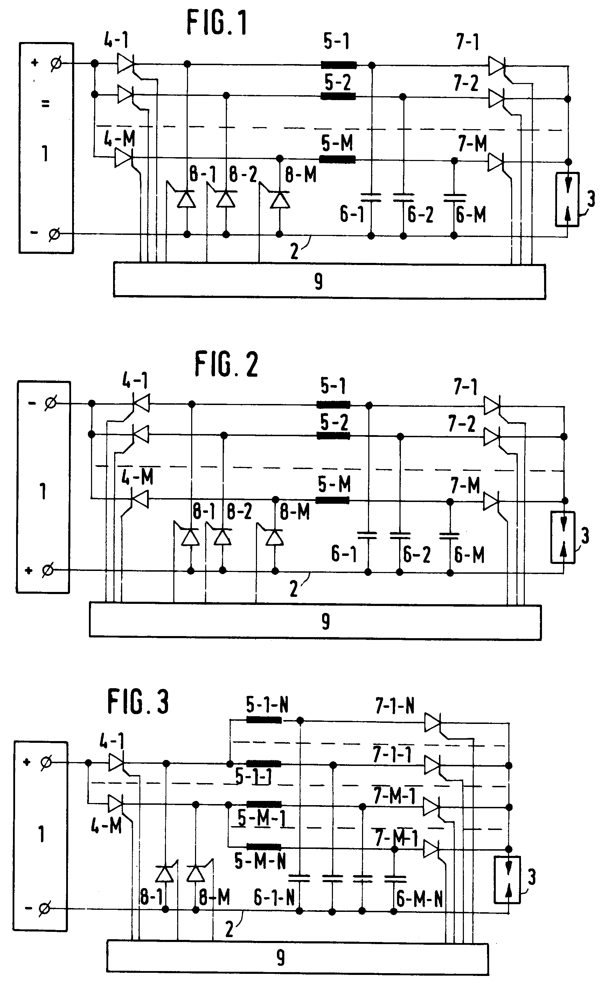

Bei dem Stromimpulsgenerator der Figur 1 sind an die positive Klemme einer Gleichspannungsquelle 1 M Lade-/Entladekreise parallel zueinander angeschlossen und gemeinsam auf eine Klemme einer Erosionslast 3 geführt. Die Lade-/Entladekreise bestehen je aus einer Reihenschaltung aus einem Ladethyristor 4-1, ..., 4-M, einer Drossel 5-1, ..., 5-M und einem Entladethyristor 7-1, ..., 7-M, wobei die Thyristoren 4-1, ..., 4-M und 7-1, ..., 7-M gleichsinnig geschaltet, d.h., die Anoden der Thyristoren 4-1, ..., 4-M sind an die positive Klemme der Gleichspannungsquelle 1 und die Kathoden der Entladethyristoren 7-1, ..., 7-M sind an eine Klemme der Erosionslast 3 angeschlossen. An die Verbindungsstelle je einer Drossel 5-1, ..., 5-M und eines Entladethyristors 7-1, ..., 7-M ist je ein Anschluß je eines Kondensators 6-1, ..., 6-M angeschlossen. An die Verbindungsstellen zwischen den Ladethyristoren 4-1, ..., 4-M und den Drosseln 5-1, ..., 5-M ist je ein Ladungsaustauschthyristor 8-1, ..., 8-M angeschlossen. Die jeweils zweiten Klemmen der Erosionslast 3, der Kondensatoren 6-1, ..., 6-M und (die Anoden) der Ladungsaustauschthyristoren 8-1, ..., 8-M sind auf eine gemeinsame Leitung 2 geführt. Die Steueranschlüsse der Thyristoren 4-1, ..., 4-M, 7-1, ...,7-M und 8-1, ..., 8-M sind an die Ausgänge einer Steuerschaltung 9 geführt.

Der Stromimpulsgenerator der Figur 2 unterscheidet sich von dem der Figur 1 dadurch, daß die Thyristoren 4-1, ..., 4-M und 7-1, ..., 7-M gegensinnig geschaltet sind, und daß die parallel zueinander geschalteten Lade-/Entladekreise an die negative und die gemeinsame Leitung 2 an die positive Klemme der Gleichspannungsquelle 1 angeschlossen sind.

Der Stromimpulsgenerator der Figur 3 unterscheidet sich von dem der Figur 1 dadurch, daß in jedem der parallel zueinander geschalteten Ladekreise mehrere Drosseln 5-1, ..., 5-M parallel zueinander geschaltet sind. Dabei sind die ersten Anschlüsse aller Drosseln jedes Ladekreises miteinander verbunden, während ihr zweiter Anschluß je an eine Klemme des Speicherkondensators dieses Ladekreiszweiges angeschlossen ist. Dabei entspricht die Anzahl der Kondensatoren 6-1, ..., 6-M der Anzahl der Drosseln. An die erste Klemme jedes Kondensators 6-1, ..., 6-M ist je ein eigener Zweig des Entladekreises mit einem eigenen Entladethyristor 7-1, ..., 7-M angeschlossen.

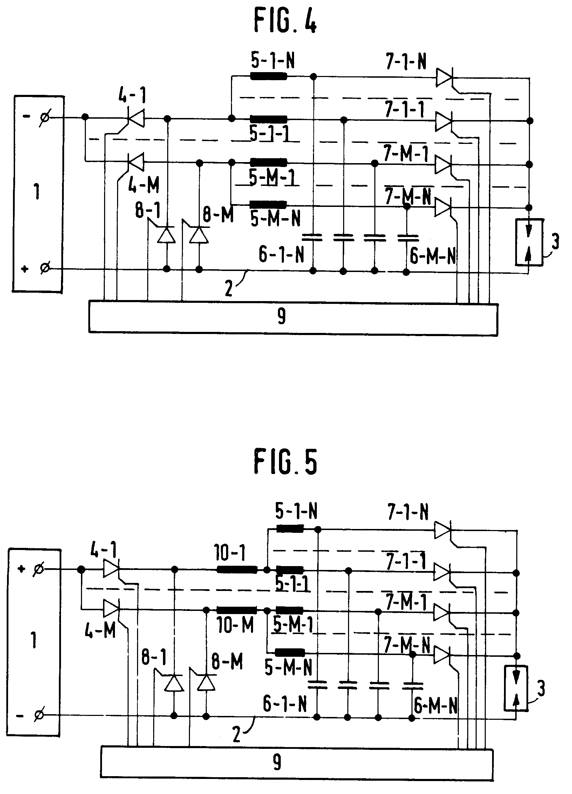

Der Stromimpulsgenerator der Figur 4 unterscheidet sich analog zu dem Unterschied zwischen den Schaltungen nach Figur 2 und 1 von dem der Figur 3 durch den gegensinnigen Anschluß von Kathode und Anode des Entladethyristors 7-1, ..., 7-M und des Ladethyristors 4-1, ..., 4-M, sowie dadurch, daß die parallelgeschalteten Lade-/Entladekreise an die negative und die gemeinsame Leitung 2 an die positive Klemme der Gleichspannungsquelle 1 angeschlossen sind.

Schließlich unterscheidet sich der Stromimpulsgenerator der Figur 5 von dem der Figur 3 dadurch, daß in jedem Ladekreis eine zusätzliche Drossel 10 vorgesehen ist, die sich zwischen der Verbindungsstelle der Anschlüsse von Ladethyristor 4-1, ..., 4-M und Ladungsaustauschthyristor 8-1, ..., 8-M und der Verbindungsstelle des ersten Anschlusses der in den Zweigen des Lade-/Entladekreises parallel zueinander geschalteten Drosseln 5-1, ..., 5-M befindet. Mit anderen Worten, den Reihenschaltungen aus je einer Drossel 5-1, ..., 5-M und je einem Entladethyristor 7-1, ..., 7-M ist jeweils eine zusätzliche Drossel 10 vorgeschaltet.

Der Stromimpulsgenerator der Figur 1 funktioniert folgendermaßen:
Auf die Steuerelektroden der Thyristoren 4-1, ..., 4-M der Ladekreise werden von der Steuerschaltung 9 gleichzeitig oder nacheinander Steuersignale gegeben. Dabei schalten die Thyristoren 4-1, ..., 4-M ein und die Kondensatoren 6-1, ..., 6-M werden über die Drosseln 5-1, ..., 5-M im Schwingbetrieb auf eine Spannung aufgeladen, die fast gleich der doppelten Spannung der Gleichspannungsquelle 1 ist. Infolgedessen schalten die Thyristoren 4-1, ..., 4-M aus. Danach werden die Steuerimpulse von der Steuerschaltung 9 an die Steuerelektroden der Entladethyristoren 7-1, ..., 7-M, je nach den Erfordernissen für die Last gleichzeitig oder nacheinander, angelegt. Dabei werden die Thyristoren 7-1, ..., 7-M eingeschaltet und die Speicherkondensatoren 6-1, ..., 6-M werden auf die Erosionslast 3 entladen. Die Kondensatoren 6-1, ..., 6-M können sowohl unter gleichzeitigem Anlegen von Steuerimpulsen an alle Thyristoren 7-1, ..., 7-M gleichzeitig als auch nacheinander oder gruppenweise entladen werden. Im ersteren Fall werden die gleichzeitig auf die Erosionslast gelangenden Stromimpulse summiert, was zu einer Verstärkung des Gesamtimpulses in der Last 3 um das M-fache führt. Im zweiten Fall, wenn die Stromimpulse von M Entladekreisen mit gleichen Intervallen zwischen den Impulsen auf die Last 3 gelangen, wird die Summen-Entlade-Folgefrequenz in der Last 3 um das M-fache erhöht. Wenn im dritten Fall die Stromimpulse gruppenweise nach einem beliebigen vorgegebenen Zeitintervall auf die Last 3 gegeben werden, erhält man in der Last eine entsprechende komplexe zeitliche Verteilung der Entladungen.

Je nach Art der Last 3 und ihrem Leistungsfaktor (cos φ) können die Entladungen in der Last 3 sowohl aperiodisch als auch periodisch (schwingend) erfolgen. Im zweiten Fall, insbesondere bei Kurzschlüssen in der Last, werden die Kondensatoren 6-1, ..., 6-M über die Last 3 auf eine Spannung aufgeladen, die der ursprünglichen Polung entgegengesetzt ist. Zur Beseitigung dieser Spannung werden nach Beendigung der Entladungen in der Last 3 und nach Ausschalten der Thyristoren 7-1, ..., 7-M Öffnungsimpulse an die Ladungsaustauschthyristoren 8-1, ..., 8-M gesendet. Diese öffnen, und es erfolgt eine umgekehrte Neuladung der Kondensatoren 6-1, ..., 6-M über die Thyristoren 8-1, ..., 8-M und die Drosseln 5-1, ..., 5-M. Nach Abschluß der Umladung werden die Thyristoren 8-1, ..., 8-M gesperrt und die Schaltung ist für den folgenden Zyklus bereit, der mit dem Zünden der Ladethyristoren 4-1, ..., 4-M einsetzt.

Der Stromimpulsgenerator der Figur 2 arbeitet zunächst ebenso wie der der Figur 1. Auf die Steuerelektroden der Ladethyristoren 4-1, ..., 4-M werden von der Steuerschaltung 9 gleichzeitig oder nacheinander Steuersignale gegeben. Dabei zünden die Thyristoren 4-1, ..., 4-M, und die Kondensatoren 6-1, ..., 6-M werden über die Drosseln 5-1, ..., 5-M im Schwingbetrieb auf die Spannung der Gleichspannungsquelle 1 aufgeladen. Nun werden im Unterschied zur Funktionsweise des Stromimpulsgenerators der Figur 1 von der Steuerschaltung 9 gleichzeitig oder nacheinander Zündimpulse auf die Steuerelektroden der Ladungsaustauschthyristoren 8-1, ..., 8-M geführt. Die Thyristoren öffnen, und es kommt zu einem Ladungsaustausch der Kondensatoren 6-1, ..., 6-M über die Thyristoren 8-1, ..., 8-M und die Drosseln 5-1, ..., 5-M im Schwingbetrieb auf eine Spannung entgegengesetzter Polarität, jedoch mit praktisch fast dem gleichen Wert. Infolge des Ladungsaustausches werden die Thyristoren 8-1, ..., 8-M gesperrt. Danach werden von der Steuerschaltung 9 negative Impulse auf die Steuerelektroden der Entladethyristoren 7-1, ..., 7-M abgegeben (gleichzeitig bzw. nacheinander bzw. zu Gruppen zusammengefaßt). Die Thyristoren 7-1, ..., 7-M zünden und die Speicherkondensatoren 6-1, ..., 6-M werden über diese Thyristoren auf die Erosionslast 3 entladen. Wegen des schwingenden Charakters der Entladungen in der Last 3 können sich die Kondensatoren 6-1, ..., 6-M teilweise auf eine Spannung entgegengesetzter Polarität umladen; diesmal aber entspricht die Polarität dieser Spannung der Spannungspolarität an den Klemmen der Gleichspannungsquelle 1. Deshalb ist der Stromimpulsgenerator sofort nach Beendigung der Entladungen in der Last und nach dem Sperren der Entladethyristoren 7-1, ..., 7-M für den folgenden Funktionszyklus bereit. Es empfiehlt sich, einen derartigen Generator zur Speisung eines Elektroerosions-Verbrauchers zu verwenden, in dem es häufig zu Kurzschlüssen kommen kann.

Der Stromimpulsgenerator der Figur 3 arbeitet ähnlich wie der der Figur 1. Ein Unterschied besteht darin, daß die Entladungen auf die Erosionslast 3 in den Ästegruppen der Entladekreise, die an denselben Ladekreis angeschlossen sind, gleichzeitig oder beinahe gleichzeitig erfolgen. Dazu werden von der Steuerschaltung 9 an die Gruppe der Entladethyristoren 7-1-1, ..., 7-1-N gleichzeitig Zündimpulse gesandt. Auf die Thyristorengruppe 7-2-1, ..., 7-2-N (ebenfalls auf alle gleichzeitig) können die Steuerimpulse sowohl gleichzeitig mit den Impulsen der Gruppe 7-1-1, ..., 7-1-N als auch zu einer anderen Zeit aufgegeben werden. Dies ist erforderlich, um ein wesentliches Überlaufen der Ladung von einem Kondensator in einem Zweig der Lade-/Entladekette auf einen ebensolchen Kondensator im benachbarten Zweig der Lade-/Entladekette über die zwei Drosseln 5 zu vermeiden. Die Drosseln dienen bei der Entladung der Kondensatoren 6-1,..., 6-M auf die Last 3 dazu, eine Überlastung eines oder mehrerer Entladethyristoren (7-1,..., 7-M) und eine unvollständige Auslastung anderer zu vermeiden, wie dies bei Schaltungen mit parallel geschalteten Thyristoren des Entladeschalters zu beobachten ist.

Der in Figur 3 dargestellte Stromimpulsgenerator ermöglicht es, in einer etwas anderen Betriebsart zu arbeiten, und zwar unter Erzeugung von M-förmigen Stromimpulsen in der Last 3. Dazu werden an eine Hälfte der Entladethyristoren der Gruppe 7-1-1, ..., 7-1-N von der Steuerschaltung 9 Steuerimpulse gesandt. Dies geschieht für einige Mikrosekunden (ungefähr 0,5 der Impulsdauer des Entladestromes in der Last 3) nach dem Senden ebensolcher Zündimpulse an die andere Hälfte derselben Entladethyristorengruppe 7-1-1, ..., 7-1-N. Durch die Überlagerung zweier Entladestromimpulse in der Last 3 ergibt sich ein M-förmiger Impuls, bei dem (nach einigen Angaben in der Literatur) sich die Leistungsfähigkeit der Dispergierung von Metallen durch Elektroerosion gegenüber gewöhnlichen Entlade-Stromimpulsen erhöht. Allerdings fließt bei einer solchen Betriebsweise ein Teil der Ladung von der Hälfte der entsprechenden Kondensatorengruppe 6-1-1, ..., 6-1-N über die Drosseln 5-1-1, ..., 5-1-N und gelangt auf die zweite Hälfte derselben Kondensatorengruppe 6-1-1, ..., 6-1-N, wodurch ein Teil der Leistung verlorengeht.

Der Stromimpulsgenerator der Figur 4 arbeitet ähnlich wie der der Figur 2, mit dem Unterschied, daß, wie auch bei dem Generator der Figur 3, die Entladungen auf die Erosionslast 3 in den Gruppen der Entladekreiszweige, die an denselben Ladekreis angeschlossen sind, gleichzeitig bzw. beinahe gleichzeitig erfolgen, indem Zündimpulse von der Steuerschaltung 9 gleichzeitig auf die gesamte Entladethyristorengruppe 7-1-1, ..., 7-1-N gesendet werden.

Der in Figur 5 gezeigte Stromimpulsgenerator arbeitet ähnlich wie der der Figur 3. Mit diesem Generator empfiehlt es sich jedoch nicht, M-förmige Impulse in der Last 3 zu erzeugen, weil bei einer derartigen Betriebsweise ein Teil der Ladung an den Speicherkondensatoren 6-1,..., 6-M verlorengeht.

## Claims

1. Stromimpulsgenerator
- mit einer Gleichspannungsquelle (1),
- mit einem Lade-/Entladekreis aus einer zwischen eine Klemme der Gleichstromquelle (1) und eine Last (3) geschalteten Reihenschaltung aus einem Ladethyristor (4), einer Drossel (5) und einem Entladethyristor (7), einem zum Entladethyristor (7) und zur Last (3) parallelgeschalteten Kondensator (6) und einem zwischen Ladethyristor (4) und Drossel (5) angeschlossenen Ladungsaustauschthyristor (8), wobei der jeweils zweite Anschluß der Last (3), des Kondensators (6) und des Ladungsaustauschthyristors (8) über eine gemeinsame Leitung (2) auf die zweite Klemme der Gleichstromquelle (1) geschaltet ist, und
- mit einer Steuerschaltung (9), deren Ausgänge mit den Steueranschlüssen der Thyristoren (4, 7, 8) verbunden sind,
dadurch **gekennzeichnet,**
daß mehrere Lade-/Entladekreise parallel zueinander geschaltet sind und in jedem Entladekreis nur ein Entladethyristor (7) vorgesehen ist.

2. Thyristor-Stromimpulsgenerator nach Anspruch 1, dadurch gekennzeichnet, daß jeder Reihenschaltung aus Drossel (5) und Entladethyristor (7) ein oder mehrere Reihenschaltungen aus je einer Drossel (5) und einem Entladethyristor (7) parallelgeschaltet sind, und daß an jede Verbindungsstelle zwischen je einer Drossel (5) und einem Entladethyristor (7) je ein Kondensator (6) angeschlossen ist.

3. Thyristor-Stromimpulsgenerator nach Anspruch 2, dadurch gekennzeichnet, daß zwischen die Verbindungsstellen zwischen den Lade- und den Ladungsaustauschthyristoren (4 bzw. 8) und die Drosseln (5) der parallelgeschalteten Reihenschaltungen aus Drossel (5) und Entladethyristor (7) je eine zusätzliche Drossel (10) geschaltet ist.
